# EUROPEAN PATENT APPLICATION

(11) **EP 4 715 336 A1**
(43) Date of publication of application: **25.03.2026**
(21) Application number: 25203134.9
(22) Date of filing: 18.09.2025
(51) Int. Cl.: G01D 5/48, G01R 33/18

(54) **DUAL COIL MAGNETOSTRICTIVE SENSOR WAVEGUIDE ASSEMBLY**

(30) Priority: 18.09.2024 US 202463696152 P
(71) Applicant: Temposonics, LLC, Cary, North Carolina 27513 (US)
(72) Inventor: SPRECHER, Arnold F., Morrisville, North Carolina, 27560 (US); MININ, Aleksey Gennadyevich, Cary, North Carolina, 27513 (US); YOUNG, Ian Lucas, Cary, North Carolina, 27511 (US)
(74) Representative: Meissner Bolte Partnerschaft mbB

(57) **Abstract**

A waveguide assembly includes a waveguide having a longitudinal axis and a magnetostrictive response pickup. The pickup includes a first coil oriented within a first plane, which is approximately parallel to the longitudinal axis, and a second coil connected in series with the first coil and oriented within a second plane, which is approximately parallel to the longitudinal axis. A central axis of the first coil is displaced a coil separation distance from a central axis of the second coil along the longitudinal axis.

## Description

### FIELD

Embodiments of the present disclosure generally relate to magnetostrictive position measurement, and more specifically, to magnetostrictive position measuring systems and methods that utilize both longitudinal and torsional waves of magnetostrictive responses.

### BACKGROUND

Magnetostrictive position measurement systems or linear position transducers are robust, high resolution instruments which have proven to be useful in many measurement and control applications. Magnetostrictive linear position systems generally include a wire waveguide and a target magnet that has a position that can vary relative to the waveguide. The location of the target magnet along the waveguide corresponds to the position to be measured.

An excitation generator of the magnetostrictive position measurement system generates an electrical excitation signal, such as a current pulse, which is conducted through the waveguide. This creates a magnetic field around the waveguide that interacts with the magnetic field of the target magnet to produce a magnetostrictive response in the waveguide at the location of the target magnet. The magnetostrictive response takes the form of a sonic wave having mechanical pulse components including a longitudinal wave corresponding to a compression of the waveguide along its longitudinal axis, and a torsional wave corresponding to a torsional strain on the surface of the waveguide about the longitudinal axis.

A transducer or sensing element of the magnetostrictive position measurement system located at an end of the waveguide is used to detect the longitudinal wave or torsional wave by converting the wave into an electrical response signal. The electrical response signal is processed to determine the position of the target magnet based on a time of flight measurement between the excitation signal and a detection of the longitudinal wave or the torsional wave.

### SUMMARY

Embodiments of the present disclosure are directed to magnetostrictive position measuring systems that utilize a waveguide assembly having a dual-coil pickup, a magnetostrictive position measuring system that includes the waveguide assembly, and a method.

One example of the waveguide assembly includes a waveguide having a longitudinal axis and a magnetostrictive response pickup. The pickup includes a first coil oriented within a first plane, which is approximately parallel to the longitudinal axis, and a second coil connected in series with the first coil and oriented within a second plane, which is approximately parallel to the longitudinal axis. A central axis of the first coil is displaced a coil separation distance from a central axis of the second coil along the longitudinal axis.

In one embodiment, the coil separation distance is approximately one-half of a wavelength of an acoustic pulse magnetostrictive response carried by the waveguide.

In one embodiment, the acoustic pulse comprises a torsional wave.

In one embodiment, the acoustic pulse comprises a longitudinal wave.

In one embodiment, the first and second planes are approximately parallel.

In one embodiment, each of the first and second coils are spiral coils.

In one embodiment, the waveguide assembly includes a first coil assembly comprising a plurality of first stacked coils connected together in series, each first stacked coil being oriented within a plane that is approximately parallel to the longitudinal axis and approximately coaxial to the other first stacked coils, wherein the plurality of first stacked coils includes the first coil, and a second coil assembly comprising a plurality of second stacked coils connected together in series, each second stacked coil being oriented within a plane that is approximately parallel to the longitudinal axis and approximately coaxial to the other second stacked coils, wherein the plurality of second stacked coils includes the second coil.

In one embodiment, the first and second coils each have a diameter of approximately 3-10mm.

In one embodiment, each of the first and second coils are positioned on the same side of the waveguide.

In one embodiment, the waveguide assembly includes an electromagnetic reflector, wherein the waveguide is located between the reflector and the first and second coils.

In one embodiment, the electromagnetic reflector is electrically grounded.

In one embodiment, the waveguide assembly includes at least one magnetic shield member, each magnetic shield member comprising a ferromagnetic material, wherein a plane extending perpendicular to the longitudinal axis and through one of the first or second coils, extends through the at least one magnetic shield member.

In one embodiment, the at least one magnetic shield member comprises a lower magnetic shield member, and the first and second coils are located between the lower magnetic shield member and the waveguide.

In one embodiment, the at least one magnetic shield member comprises an upper magnetic shield member, and the waveguide is positioned between the first and second coils and the upper magnetic shield member.

In one embodiment, the first and second coils are located closer to a proximal end of the waveguide than a distal end of the waveguide, the upper and lower magnetic shield members each include a proximal end corresponding to the proximal end of the waveguide and a distal end corresponding to the distal end of the waveguide, and a position of the distal end of the lower magnetic shield member along the longitudinal axis is offset toward the distal end of the waveguide relative to a position of the distal end of the upper magnetic shield member along the longitudinal axis.

An example of the magnetostrictive position measuring system includes a waveguide having a longitudinal axis, an excitation generator configured to generate an excitation signal that is conducted through the waveguide, a target magnet, a magnetostrictive response pickup, and a signal conditioner. The target magnet is moveable along the longitudinal axis relative to the waveguide and is configured to generate an acoustic pulse carried by the waveguide in response to the excitation signal. The magnetostrictive response pickup includes a first coil oriented within a first plane, which is approximately parallel to the longitudinal axis, and a second coil connected in series with the first coil and oriented within a second plane, which is approximately parallel to the longitudinal axis. A central axis of the first coil is displaced a coil separation distance from a central axis of the second coil along the longitudinal axis. The signal conditioner is configured to amplify signals conducted through the first and second coils in response to the acoustic pulse and output a conditioned response signal.

In one embodiment, each of the first and second coils are spiral coils.

In one embodiment, the coil separation distance is approximately one-half of a wavelength of the acoustic pulse carried by the waveguide.

In one embodiment, the acoustic pulse comprises a torsional wave.

In one embodiment, the acoustic pulse comprises a longitudinal wave.

In one embodiment, the first and second planes are approximately parallel.

In one embodiment, each of the first and second coils are formed in a layer of a printed circuit board.

In one embodiment, the system includes a first coil assembly comprising a plurality of first stacked coils connected together in series, each first stacked coil being oriented within a plane that is approximately parallel to the longitudinal axis and approximately coaxial to the other first stacked coils, wherein the plurality of first stacked coils includes the first coil, and a second coil assembly comprising a plurality of second stacked coils connected together in series, each second stacked coil being oriented within a plane that is approximately parallel to the longitudinal axis and approximately coaxial to the other second stacked coils, wherein the plurality of second stacked coils includes the second coil.

In one embodiment, each coil has a diameter of approximately 3-10mm.

In one embodiment, each of the first and second coils are positioned on the same side of waveguide.

In one embodiment, the system includes an electromagnetic reflector, wherein each coil is located between the reflector and the waveguide.

In one embodiment, the electromagnetic reflector is electrically grounded.

In one embodiment, the system includes at least one magnetic shield member, each comprising a ferromagnetic material, wherein a plane extending perpendicular to the longitudinal axis and through one of the first or second coils, extends through the at least one magnetic shield member.

In one embodiment, the at least one magnetic shield member comprises a lower magnetic shield member, and the first and second coils are located between the lower magnetic shield member and the waveguide.

In one embodiment, the at least one magnetic shield member comprises an upper magnetic shield member, and the waveguide is positioned between the first and second coils and the upper magnetic shield member.

In one embodiment, the first and second coils are located closer to a proximal end of the waveguide than a distal end of the waveguide, the upper and lower magnetic shield members each include a proximal end corresponding to the proximal end of the waveguide and a distal end corresponding to the distal end of the waveguide, and a position of the distal end of the lower magnetic shield member along the longitudinal axis is offset toward the distal end of the waveguide relative to a position of the distal end of the upper magnetic shield member along the longitudinal axis.

In one embodiment, the first and second coils having an impedance (e.g., about 1-3 ohms) and the signal conditioner includes a first stage amplifier having an impedance that approximately matches the impedance of coils, the first stage amplifier configured to amplify the signals conducted through the first and second coil and output corresponding first stage signal, and a second stage amplifier having a high impedance configured to amplify the first stage signals and output corresponding second stage signals.

In one embodiment, an output section of the first stage amplifier has an impedance (e.g., about 24 - 50 kohms), and an input section of the second stage amplifier has an impedance that approximately matches the impedance of the output section of the first stage amplifier.

In one embodiment, the first stage amplifier has a first gain (e.g., approximately 800-1200), and the second stage amplifier has a second gain that is approximately one one-hundredth of the first gain (e.g., approximately 8-12).

In one embodiment, the signal conditioner includes a rectification circuit configured to rectify the second stage signals, and a demodulator configured to demodulate the rectified second stage signals.

In one embodiment, the system includes a controller configured to determine a position of the target magnet along the waveguide using the conditioned response signal.
One example of the method includes forming a waveguide assembly including providing a waveguide having a longitudinal axis, and forming a magnetostrictive response pickup. Forming the magnetostrictive response pickup includes forming a first coil that is oriented within a first plane, which is approximately parallel to the longitudinal axis, and forming a second coil that is connected in series with the first coil and is oriented within a second plane, which is approximately parallel to the longitudinal axis, wherein a central axis of the first coil is displaced a coil separation distance from a central axis of the second coil along the longitudinal axis.

In further embodiments, the coil separation distance can be approximately one-half of a wavelength of an acoustic pulse magnetostrictive response carried by the waveguide; and/or wherein the first and second planes are approximately parallel; and/or wherein each of the first and second coils are spiral coils; and/or wherein the first and second coils each have a diameter of approximately 3-10mm; and/or wherein each of the first and second coils are positioned on the same side of waveguide.

If desired, forming the first coil comprises forming the first coil using conductive traces in a printed circuit board; and/or
forming the second coil comprises forming the second coil using conductive traces in the printed circuit board; and/or
forming the first coil comprises forming a first coil assembly comprising a plurality of first stacked coils connected together in series, each first stacked coil being oriented within a plane that is approximately parallel to the longitudinal axis and approximately coaxial to the other first stacked coils, wherein the plurality of first stacked coils includes the first coil; and/or
forming the second coil comprises forming a second coil assembly comprising a plurality of second stacked coils connected together in series, each second stacked coil being oriented within a plane that is approximately parallel to the longitudinal axis and approximately coaxial to the other second stacked coils, wherein the plurality of second stacked coils includes the second coil.

In yet another embodiment, the method can comprise forming an electromagnetic reflector, wherein the waveguide is located between the reflector and the first and second coils, wherein if desired, the method can comprise electrically grounding the electromagnetic reflector.

If desired, the method can include forming magnetic shield members. For instance, the method can comprise forming at least one magnetic shield member, each magnetic shield member comprising a ferromagnetic material, wherein a plane extending perpendicular to the longitudinal axis and through one of the first or second coils, extends through the at least one magnetic shield member, wherein forming the at least one magnetic shield member can comprise forming a lower magnetic shield member, and wherein the first and second coils are located between the lower magnetic shield member and the waveguide; and/or
forming the at least one magnetic shield member can comprise forming an upper magnetic shield member, wherein the waveguide is positioned between the first and second coils and the upper magnetic shield member; and/or
the first and second coils are located closer to a proximal end of the waveguide than a distal end of the waveguide, wherein the upper and lower magnetic shield members each include a proximal end corresponding to the proximal end of the waveguide and a distal end corresponding to the distal end of the waveguide, and wherein a position of the distal end of the lower magnetic shield member along the longitudinal axis is offset toward the distal end of the waveguide relative to a position of the distal end of the upper magnetic shield member along the longitudinal axis.

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter. The claimed subject matter is not limited to implementations that solve any or all disadvantages noted in the Background.

### BRIEF DESCRIPTION OF THE DRAWINGS

FIG. 1 is a schematic pictorial view of an example of a magnetostrictive position measuring system in accordance with embodiments of the present disclosure.
FIG. 2 is a simplified circuit diagram of an example of a magnetostrictive position measuring system in accordance with embodiments of the present disclosure.
FIGS. 3 and 4 are simplified top and side cross-sectional views, respectively, of an example of a magnetostrictive response pickup in accordance with embodiments of the present disclosure.
FIG. 5 is a simplified side cross-sectional view of a portion of an example magnetostrictive response pickup in accordance with embodiments of the present disclosure.
FIG. 6 is a front isometric view of an example of a stack of coils in accordance with embodiments of the present disclosure.
FIG. 7 is a simplified block diagram of an example of a signal conditioner in accordance with embodiments of the present disclosure.
FIG. 8 is a circuit diagram of an example of a signal conditioner in accordance with embodiments of the present disclosure.

### DETAILED DESCRIPTION OF ILLUSTRATIVE EMBODIMENTS

Embodiments of the present disclosure are described more fully hereinafter with reference to the accompanying drawings. Elements that are identified using the same or similar reference characters refer to the same or similar elements. The various embodiments of the present disclosure may, however, be embodied in many different forms and should not be construed as limited to the specific embodiments set forth herein. Rather, embodiments are described so that this disclosure will be thorough and complete, and will fully convey the scope of the embodiments to those skilled in the relevant art.

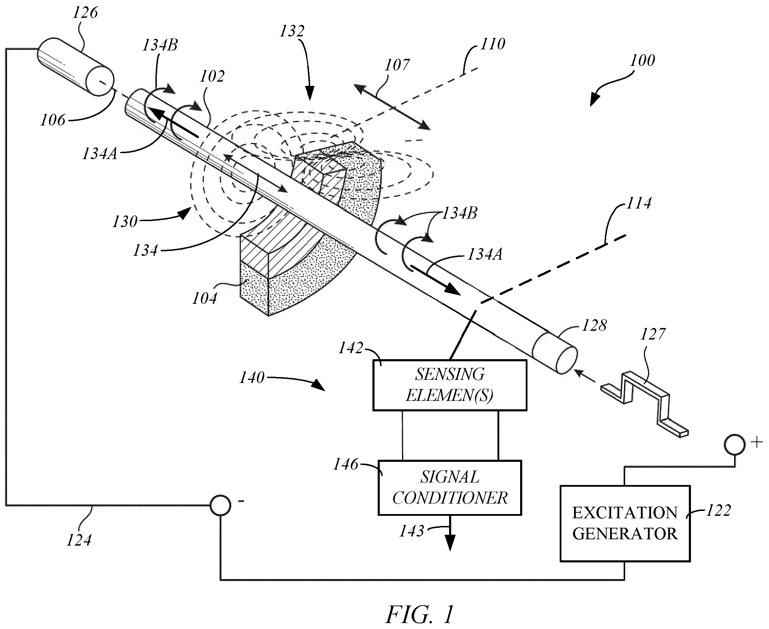

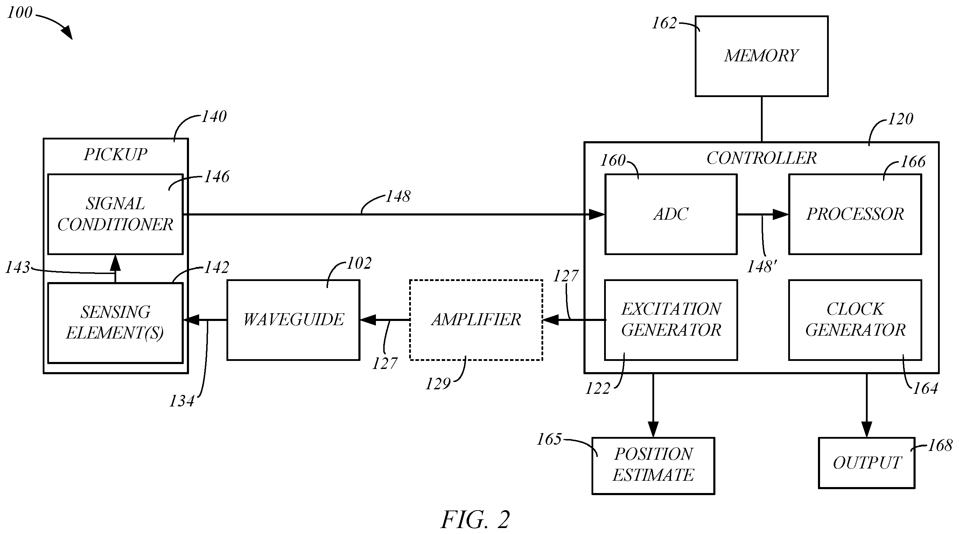

FIGS. 1 and 2 respectively are a schematic pictorial view and a simplified circuit diagram of an example of a magnetostrictive position measuring system 100, in accordance with embodiments of the present disclosure. The system 100 includes a wire having magnetoelastic properties, referred to as a waveguide 102 and one or more target magnets 104 (one of which is indicated in FIG. 1) located adjacent to the waveguide 102 (e.g., bar magnet) and/or surrounding the waveguide 104 (e.g., ring magnet).

Each target magnet 104 is moveable relative to the waveguide 102 along a longitudinal axis 106, as indicated by arrow 107, and has a position 110 along the axis 106 from a reference position 114 that is to be detected by the system 100. Each target magnet 104 can move independently along the waveguide 102 and may comprise one or more magnets (e.g., permanent magnets or electromagnets), such as a single magnet or a stack of magnets.

A controller 120 (FIG. 2) of the system 100 includes an excitation generator 122. A closed electrical circuit may be formed by the generator 122, the waveguide 102, and a return wire 124 that connects a distal end 126 of the waveguide 102 back to the excitation generator 122, as shown in FIG. 1. The generator 122 may be in the form of an electric pulse generator that generates an electrical excitation signal in the form of an electrical current pulse 127, which is delivered to a proximal end 128 of the waveguide 102. An amplifier 129 (FIG. 2) may be used to amplify the electrical pulse 127 before applying it to the waveguide 102.

The transmission of the electrical pulse 127 through the waveguide 102 generates a magnetic field 130 that interacts with the magnetic field 132 of the magnet 104 to generate a mechanical magnetostrictive response (e.g., acoustic waves) 134 in the waveguide 102, which includes a longitudinal wave 134A (e.g., longitudinal compression) and a torsional wave 134B (e.g., torsional strain) in the waveguide 104, as indicated in FIG. 1.

The magnetostrictive response 134 travels from both sides of the magnet 104 along the waveguide 102. For example, a portion of the magnetostrictive response 134 may travel along the waveguide 102 from the position 110 of the magnet 104 toward the end 126 of the waveguide 102 and possibly to a damper (not shown) that reduces or eliminates propagation of the acoustic waves back through the waveguide 102. Additionally, a portion of the magnetostrictive response 134 travels from the position 110 of the magnet 104 toward the end 128 of the waveguide, at which a magnetostrictive response pickup 140 is used to sense the response 134.

The pickup 140 includes one or more sensing elements 142 that are configured to sense the magnetostrictive response 134 and generate at least one electrical response signal 143 that is based on the magnetostrictive response 134. That is, the electrical response signal or signals 143 includes an indicator of the longitudinal wave 134A and/or an indicator of the torsional wave 134B. The one or more indicators may comprise a transient change or pulse in the magnitude of the signal 143, for example, which can be detected by the controller 120 to determine the position 110 of the target magnet using conventional techniques.

A signal conditioner 146 of the pickup 140 may be used to amplify or otherwise condition (e.g., rectify, filter, etc.) the signals 143 before delivering a conditioned response signal 148 to the controller 120, as indicated in FIG. 2. Thus, in some embodiments, the response signal 148 may be the original signal 143 generated by the sensing element(s) 142, such as when the pickup 140 does not include the signal conditioner 146, or the response signal 148 may be a conditioned or processed form of the signal 143 generated by the sensing element(s) 142.

The controller 120 may process the one or more response signals 148 using any suitable technique. In one example, the controller 120 includes an analog-to-digital converter (ADC) 160 that converts each of the one or more analog electrical response signals 148 into corresponding digital samples 148'. For example, the ADC 160 may sample each of the one or more analog response signals 148 at a frequency that allows the response signal 148 to be further processed by the controller 120. The digital samples 148' of each response signal 148 may be stored in a memory 162 of the system 100 or a buffer of the controller 120, for example.

The controller 120 may include a clock generator 164 that begins a timing routine when the magnetostrictive excitation is generated by the excitation generator 122, such as when the electrical current pulse 127 is generated. The clock generator 164 may be used to determine the time of each digital sample 148' relative to the generation of the magnetostrictive excitation 127. The digital samples 148' may be analyzed to detect the corresponding time of flight of the indicator of the magnetostrictive response 148, from which position 110 of the target magnet 104 may be determined due to the known speed of the corresponding longitudinal acoustic wave 134A or torsional acoustic wave 134B through the waveguide 102, in accordance with conventional techniques. The controller 120 may output a position estimate 165 that indicates the position 110.

The controller 120 may comprise one or more processors 166 that control components of the system 100, and/or perform one or more functions described herein in response to the execution of instructions, which may be stored locally in non-transitory memory 162 or computer-readable media (e.g., flash memory, optical data storage, magnetic data storage, etc.) of the system 100. In some embodiments, each processor 166 of the controller 120 may comprise one or more computer-based systems, control circuits, microprocessor-based engine control systems, and/or programmable hardware components (e.g., field programmable gate array), for example.

In some embodiments, the at least one processor 166 is configured to analyze the digital samples 148' of the response signal 148 to detect the indicator of the longitudinal wave 134A and/or the indicator of the torsional wave 134B, and establish the time of flight for the indicator. In some embodiments, the controller 120 is configured to calculate a position candidate 110 of the target magnet 104 along the axis 106 of the waveguide 102 based on the time of flight of the detected indicator.

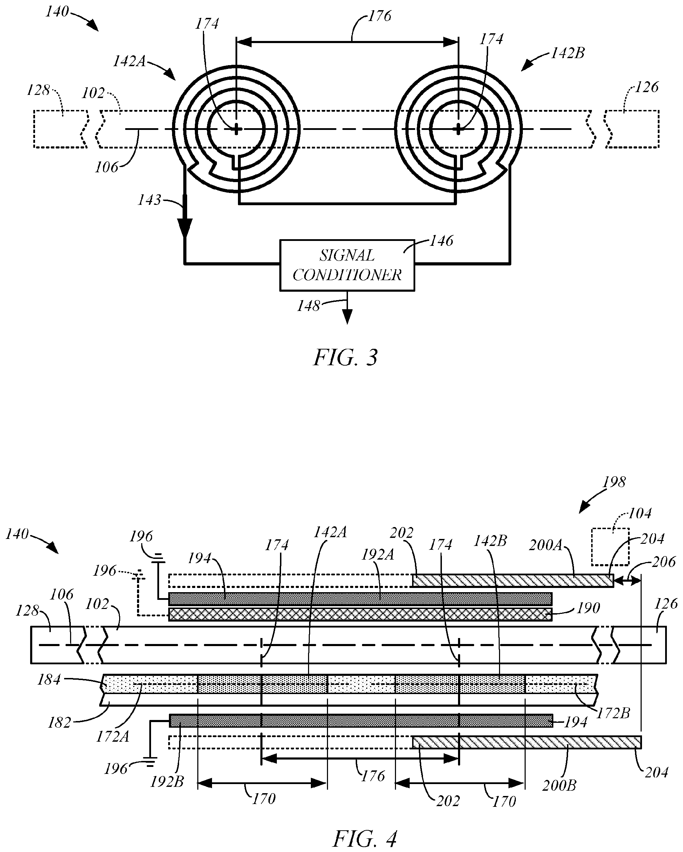

FIGS. 3 and 4 are simplified top and side cross-sectional views, respectively, of an example of a pickup 140, in accordance with embodiments of the present disclosure. The pickup includes two or more coils 142, such as coils 142A and 142B, for example. Each of the coils 142 operates as an antenna, in which a response signal 143 in the form of an electrical current is generated in response to the magnetostrictive response or acoustic wave 134 traveling in the waveguide 102 passing by the coil 142 due to electromagnetic induction.

The coils 142A and 142B are connected in series with each other and may take on any suitable form. In one example, each coil 142 may have a diameter 170 of approximately 3-10 millimeters, and/or may be in the form of a spiral coil, such as an Archimedean spiral, as shown in FIG. 3, or another suitable form. The coils 142 may take the form of pancake coils, in which the coils 142A and 142B may be respectively situated or oriented in planes 172A and 172B, which are substantially or approximately parallel (e.g., +/- 10 degrees) to the longitudinal axis 106 of the waveguide 102. In some embodiments, the planes 172A and 172B are approximately parallel (e.g., +/- 10 degrees) to each other, and they may be aligned such that the coils 142A and 142B are formed substantially or approximately in the same plane or planes. Each coil 142 has a corresponding central axis 174. The central axes 174 may be substantially or approximately perpendicular (e.g., +/- 10 degrees) to the longitudinal axis 106 of the waveguide 102 and substantially or approximately parallel (e.g., +/- 10 degrees) to each other.

The coils 142 may be configured such that the indicator in the current signals 143 generated in the coils 142 in response to the magnetostrictive acoustic wave or pulse 134 constructively interfere with each other and boost the amplitude of the indicator in the response signal 143. In one embodiment, the central axes 174 are separated from each other by a separation distance 176 that is equal to approximately one-half of the wavelength of the acoustic wave 134 that is targeted by the pickup 140, to promote constructive interference of the current signals 143 produced in the coils 142 while also boosting common mode noise rejection.

A magnetostrictive longitudinal acoustic wave or pulse 134A may travel at approximately 1600 m/s through a conventional waveguide 102 and have a frequency of about 150 - 175 kHz and a wavelength of approximately 11 mm, for example. Thus, when the longitudinal wave 134B in such a waveguide is targeted by the pickup 140, the separation distance 176 is set to about 5-6 mm to generate constructive interference in the indicators in the signals 143 generated in the coils 142 in response to a longitudinal wave 134A in the waveguide 102.

A magnetostrictive torsional acoustic wave or pulse 134B may travel through a conventional waveguide 102 at approximately 2800 meters/second (m/s) and have a frequency of about 250-300 kHz and a wavelength of approximately 1.1 cm, for example. Thus, when such a torsional wave 134B is targeted by the pickup 140, the separation distance 176 between the coils 142 is set to one-half the wavelength of the torsional wave, thus approximately 5.5 millimeters (mm).

Additionally, the coils 142 may be wound in opposite directions, as shown in FIG. 3, to promote constructive interference of the current response signals 143 generated in response to the magnetostrictive wave or pulse 134. Thus, the coil 142A may be wound in a clockwise direction and the coil 142B may be wound in a counterclockwise direction, for example, as shown in FIG. 3.

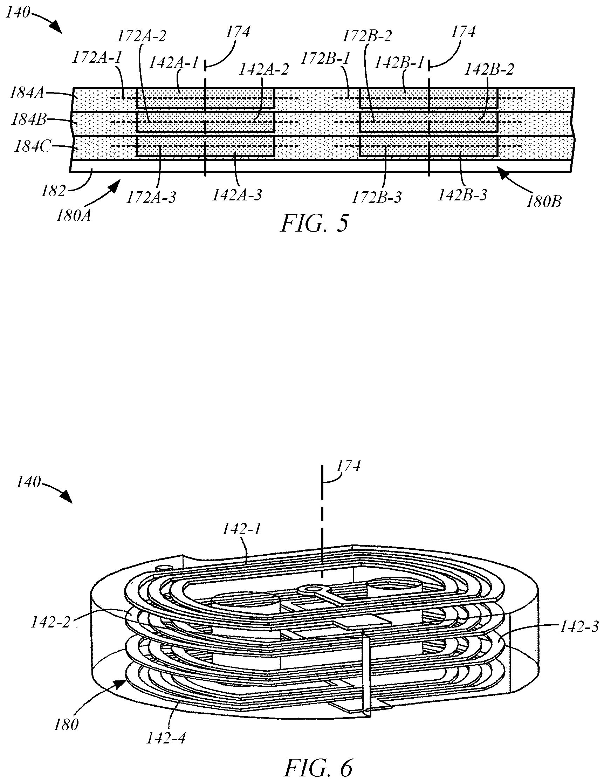

In other embodiments, the pickup 140 may comprise stacks 180 of two or more of the coils 142, as shown in FIG. 5, which is a simplified side cross-sectional view of a portion of the pickup 140, in accordance with embodiments of the present disclosure. The example pickup 140 of FIG. 5 includes a stack 180A of coils 142A-1, 142A-2 and 142A-3 connected in series, and a stack 180B of coils 142B-1, 142B-2 and 142B-3 connected in series. FIG. 6 is a front isometric view of an example of a stack 180 comprising four coils 142-1, 142-2, 142-3 and 142-4 connected in series, in accordance with embodiments of the present disclosure. Each stack 180 of multiple coils 142 operates to increase the amplitude of the response signal 143 generated in the coils in response to the passage of the magnetostrictive acoustic pulse 134 through the waveguide 102 over that generated by a single one of the coils 142.

The coils 142 of each stack 180 may share a common central axis 174. Additionally, the coils 142 may each be oriented in a corresponding plane, such as planes 172A-1, 172A-2 and 172A-3 for coils 142A-1, 142A -2 and 142A-3, and planes 172B-1, 172B-2 and 172B-3 for coils 142B-1, 142B-2 and 142B-3, respectively, all of which are approximately parallel to the longitudinal axis 106 of the waveguide 102 (not shown). Additionally, the plane 172A of each coil 142A in the stack 180A may respectively align with the plane 172B of the corresponding coil 142B in the stack 180B, as generally shown in FIG. 5. Thus, the plane 172A-1 containing the coil 142A-1 may be aligned with the plane 172B-1 containing the coil 142B-1, for example.

The coils 142 may be formed using any suitable technique. In one embodiment, the coils 142 are formed by traces in a printed circuit board 182. Thus, each coil 142 may be formed by conductive traces in a single layer 184 of the printed circuit board 182, as indicated in FIG. 4. When the coils 142 are formed in stacks 180, the coils 142 may be formed by conductive traces in multiple layers 184, such as layers 184A-C, of a printed circuit board 182, as shown in FIG. 5. Each of the coils 142 may be connected to the coil in a higher and/or lower layer 184 via a connection between the layers 184.

The pickup 140 may include features that operate to boost the amplitude of the indicator of the magnetostrictive pulse 134 in the response signal 143 and improve the signal to noise ratio of the response signal 143. In one embodiment, the pickup 140 includes an electromagnetic reflector 190, and the waveguide 102 is positioned between the reflector 190 and the coils 142, as shown in FIG. 4. The reflector 190 may be formed by a layer or sheet of a suitable conductive material (e.g., copper) that overlays the waveguide 102.

The reflective layer 190 generally operates to reflect electromagnetic energy corresponding to the magnetostrictive response 134 travelling radially outward from the waveguide 102 toward the coils 142. This boosts the magnitude of the electromagnetic energy at the coils 142 and, thus, the current signal 143 generated in the coils 142 in response to the electromagnetic energy.

In one embodiment, the pickup 140 includes one or more electromagnetic interference (EMI) shields 192 located outside the waveguide 102 and/or the coils 142. The one or more EMI shields 192 operate to reduce interference from electromagnetic signals from sources outside of the waveguide 102, thereby improving the signal to noise ratio of the response signal 143. Each EMI shield 192 generally comprises a layer 194 of conductive material that is connected to electrical ground 196.

For example, the pickup may include a top EMI shield 192A located outside the waveguide 102 and/or a bottom EMI shield 192B located outside the coils 142, such that the waveguide 102 and the coils 142 are positioned between the shields 192A and 192B, as shown in FIG. 4. The pickup 142 may also include side EMI shields that extend along the sides of the waveguide 102 and the coils 142 to fill in gaps between the EMI shields 192A and 192B. The shields 192A and 192B may be portions of a single shield 192 that generally extends around the waveguide 102 and the coils 142. In one embodiment, the reflector 190 is connected to electrical ground 196 to form an EMI shield and possibly replace the top EMI shield 192A.

In some embodiments, the pickup 140 includes a magnetic shield 198 located near the coils 142. The magnetic shield 198 assists in reducing the effect the magnetic field 132 of the target magnet 104 may have on the response signal 143 as it nears the coils 142. This reduces the "null region" of the system 100, which is the region near the coils 142 where the position 110 of the target magnet 104 cannot be determined due to magnetic interference. Thus, the magnetic shield 198 extends the operational range of the target magnet 104 along the waveguide 102 by reducing the null region at the coils 142, such as to about 1 inch, for example.

The magnetic shield 198 may take on various forms. In one example, the magnetic shield 198 includes an upper magnetic shield member 200A and/or a lower magnetic shield member 200B. Each of the magnetic shield members 200 may be formed of a suitable ferromagnetic material, such as iron, low carbon steel, a nickel-iron ferromagnetic alloy (e.g., Mu-metal), or another suitable ferromagnetic material.

Each magnetic shield member 200 extends over at least one of the coils 142. In the example shown in FIG. 4, the magnetic shield members 200 (solid lines) each overlay or underlay the coil 142B, but the magnetic shield members 200 may be extended toward the end 128 of the waveguide 102 such that they underlay or overlay both of the coils 142A and 142B, as indicated in phantom lines. As a result, a plane extending perpendicularly to the longitudinal axis 106 of the waveguide 102, such as one aligned with the central axis 174 of the coil 142B may extend through each of the at least one magnetic shield member 200 and at least one of the coils 142 (e.g., coil 142B).

The upper and lower magnetic shield members 200A and 200B each have a proximal end 202 corresponding to the end 128 of the waveguide 102 and a distal end 204 corresponding to the end 126 of the waveguide 102. The proximal end 202 and the distal end 204 of each magnetic shield member 200 may be aligned with each other. In one embodiment, the distal end 204 of the lower magnetic shield member 200B is offset a distance 206, such as 1-5mm, toward the distal end 126 of the waveguide 102 along the longitudinal axis 106 relative to the distal end 204 of the upper magnetic shield member 200A, as shown in FIG. 4. This arrangement can provide additional shielding to the bottom side of the coils 142 from magnetic interference while reducing the null region of the system 100, such as when the target magnet 104 (e.g., a bar magnet) is located above the upper magnetic shield 202A.

In some embodiments, the coils 142 are generally low-impedance coils having an impedance of around 1 ohm or less that generate a signals 143 that may be too weak (e.g., about 40-60 microvolts) for processing by the controller 120. As a result, in some embodiments, the pickup 140 includes the signal conditioner 146 that operates to amplify the signals 143 to produce corresponding conditioned response signals 148 that may be used by the controller 120 to detect the indicator of the magnetostrictive response 134 sensed by the coils 142 and determine the position 110 of the magnet 104.

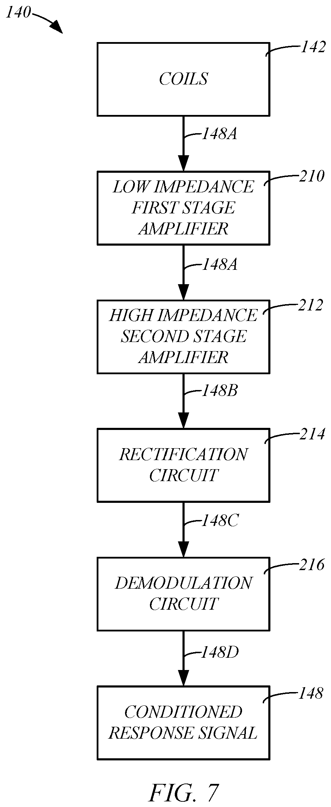

FIG. 7 is a simplified block diagram of an example of the signal conditioner 146, in accordance with embodiments of the present disclosure. In some embodiments, the signal conditioner 146 includes a low impedance first stage amplifier 210 that receives the signals 143 from the coils 142 and amplifies the signals 143 to produce amplified signals 148A. The input impedance of the first stage amplifier 210 generally matches the low output impedance of the coils 142 (e.g., about 1 ohm) for efficient energy transfer. The first stage amplifier 210 may have a gain of about 800-1200, such as about 1000 (e.g., +/- 100).

In some embodiments, the signal conditioner 146 includes a second stage amplifier 212 having a relatively high input impedance to match a relatively high output impedance (e.g., about 24 - 50 kohms) of the first stage amplifier 210. The second stage amplifier 212 receives the signals 148A from the first stage amplifier 210 and amplifies the signals 148A to produce amplified signals 148B. The second stage amplifier 212 may have a gain of about 8-12, such as about 10 (e.g., +/- 2).

The signal conditioner 146 may also include a rectification circuit 214 that operates to rectify the oscillatory signals 148B received from the second stage amplifier 212 to produce rectified signals 148C. The rectification circuit 214 may provide passive rectification using a suitable diode bridge, active rectification using bipolar transistors, or another suitable circuit.

A demodulation circuit 216 may be used to demodulate the signals 148C to produce a demodulated signal 148D, in which the indicator of the magnetostrictive response 134 has been clarified for detection by the controller 120. In some embodiments, the demodulation circuit 216 may comprise a suitable low-pass filter.

The controller 120 may process the conditioned response signal 148 received from the signal conditioner 146 to detect the indicator and determine the position 110 (FIG. 1) of the target magnet 104 along the longitudinal axis 106 of the waveguide 102.

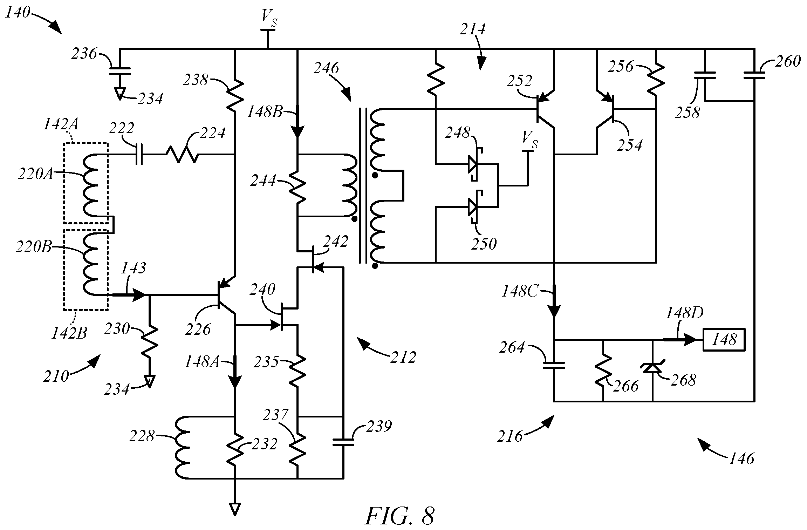

FIG. 8 is a circuit diagram of an example of the signal conditioner 146, in accordance with embodiments of the present disclosure. Those skilled in the art understand that the example circuitry of the signal controller 146 may take on other forms than that shown in FIG. 8 while performing similar functions.

In the example circuitry of the signal controller 146, the coils 142A and 142B are represented by inductors 220A and 220B, which are connected in series. Capacitor 222 and resistor 224 operate to augment the intrinsic inductance, capacitance and resistance of the coils 142A and 142B to produce a band pass transfer function having upper and lower cutoff frequencies that are tuned to the targeted frequency of the indicator in the response signal 143. For example, the capacitor 222 (e.g., about 0.27 microfarad) and the resistor 224 (about 3.9 ohms) may produce a band pass transfer function having a lower cutoff at about 50 kHz and an upper cutoff at about 600 kHz with a -40 dB/decade roll off on both sides.

The example first stage amplifier 210 generally includes a current mode amplifier formed by a transistor 226 (e.g., PNP bipolar junction transistor), an inductor 228 and resistor 230 (e.g., about 0-10 ohms). The emitter of the bipolar junction transistor 226 is biased using a supply voltage Vs (e.g., about 9 VDC) and the base is biased by a voltage across the resistor 230 from the current signal 143 produced by the coils 142. The greater the amplitude of the current signal 143, the greater the amplitude of the current signal 148A delivered through the transistor 226.

The inductor 228 is situated in parallel with a resistor 232 (e.g., about 24 kohms) between the collector of the transistor 226 and electrical common or ground 234. The inductance of the inductor 228 generally matches the inductance of the coils 142.

Capacitor 236 (e.g., about 0.1 microfarad) and resistor 238 (e.g., about 825 ohms) may be used to forward bias the base and emitter of the transistor 226 in response to the signal 143 and enable a current to flow through the transistor 226.

Resistors 235 (e.g., about 240 ohms) and 237 (e.g., about 470 ohms), and capacitor 239 (e.g., about 0.22 µfarad) operate to set the gain in the second stage amplifier 212.

The gain of the first stage amplifier 210 may be about 800-1200, such as about 1000 (e.g., +/- 100), which basically corresponds to the ratio of the inductance of the inductor 228 to the inductance of the coils 142. The output signal 148A from the first stage amplifier 210 may have a voltage of about 40 - 60 mV, such as 50 mV, for example.

The example second stage amplifier 212 includes a pair of field-effect transistors (FETs) 240 and 242 in a cascode transistor arrangement, which is useful in minimizing regenerative feedback energy and preventing uncontrolled oscillation of the amplified signal. The FET 240, which may have a high impedance (e.g., about 1 giga-ohm), is coupled to the voltage across the inductor 228. When the FET 240 conducts, the FET 242 is driven to conduct, thereby causing the current signal 148B to be conducted through the resistor 244 and a transformer 246, which provides the gain of about 8-12, such as about 10 (e.g., +/-1), of the second stage amplifier. The current signal 148B may have a voltage of about 500 mV, for example. The indicator of the magnetostrictive response in the signal 148B has a sinusoidal oscillatory pattern that appears as a pulse.

The rectification circuit 214, which may take on any suitable form, is connected to the output signal 148B of the second stage amplifier through the transformer 246. In the example rectification circuit 214 shown in FIG. 8, the oscillatory signal 148B output from the transformer 246 is rectified by an active rectifying arrangement formed by Shottky diodes 248 and 250, transistors 252 and 254, resistor 256 (e.g., about 100k ohms) and capacitors 258 (e.g., about 0.1 microfarads) and 260 (e.g., about 33 microfarads) to form the output signal 148C.

The output signal 148C from the rectification circuit 214 is delivered through a low pass filter 262 of the demodulation circuit 216 formed by the arrangement of a capacitor 264 (e.g., 180 picofarads), a resistor 266 (e.g., 11 kohms) and a diode 268, which may block frequencies above about 100 kHz, for example. The filtered output signal 148D may have a voltage of approximately 4V.

The controller 120 processes the filtered output signal 148D to detect the pulse that forms the indicator of the magnetostrictive response 134 and the position 110 of the target magnet 104 using conventional techniques. In some embodiments, the indicator pulse in the signal 148D is treated as a carrier wave and the envelope of the pulse is detected by the controller 120 and used to determine the position 110 of the target magnet 104 using the process described in U.S. Pat. No. 11,543,269, which is incorporated herein by reference in its entirety.

Additional embodiments relate to the methods of detecting the position 110 of the target magnet using the coils 142 described above.

Although the embodiments of the present disclosure have been described with reference to preferred embodiments, workers skilled in the art will recognize that changes may be made in form and detail without departing from the spirit and scope of the present disclosure.

Functions recited herein may be performed by a single controller or processor, multiple controllers or processors, or at least one controller or processor. As used herein, when one or more functions are described as being performed by a controller (e.g., a specific controller), one or more controllers, at least one controller, a processor (e.g., such as a specific processor), one or more processors or at least one processor, embodiments include the performance of the function(s) by a single controller or processor, or multiple controllers or processors, unless otherwise specified. Furthermore, as used herein, when multiple functions are performed by at least one controller or processor, all of the functions may be performed by a single controller or processor, or some functions may be performed by one controller or one processor, and other functions may be performed by another controller or processor. Thus, the performance of one or more functions by at least one controller or processor does not require that all of the functions are performed by each of the controllers or processors.

The preferred aspects of the present disclosure may be summarized as follows:
1. A waveguide assembly for a magnetostrictive position measuring system, the waveguide assembly comprising:
   a waveguide having a longitudinal axis; and
   a magnetostrictive response pickup comprising:
      a first coil oriented within a first plane, which is approximately parallel to the longitudinal axis; and
      a second coil connected in series with the first coil and oriented within a second plane, which is approximately parallel to the longitudinal axis,
      wherein a central axis of the first coil is displaced a coil separation distance from a central axis of the second coil along the longitudinal axis.
2. The waveguide assembly according to aspect 1, wherein the coil separation distance is approximately one-half of a wavelength of an acoustic pulse magnetostrictive response carried by the waveguide.
3. The waveguide assembly according to any of aspects 1 to 2, wherein the acoustic pulse comprises a torsional wave.
4. The waveguide assembly according to any of aspects 1 to 3, wherein the acoustic pulse comprises a longitudinal wave.
5. The waveguide assembly according to any of aspects 1 to 4, wherein the first and second planes are approximately parallel.
6. The waveguide assembly according to any of aspects 1 to 5, wherein each of the first and second coils are spiral coils.
7. The waveguide assembly according to any of aspects 1 to 6, further comprising:
   a first coil assembly comprising a plurality of first stacked coils connected together in series, each first stacked coil being oriented within a plane that is approximately parallel to the longitudinal axis and approximately coaxial to the other first stacked coils, wherein the plurality of first stacked coils includes the first coil; and
   a second coil assembly comprising a plurality of second stacked coils connected together in series, each second stacked coil being oriented within a plane that is approximately parallel to the longitudinal axis and approximately coaxial to the other second stacked coils, wherein the plurality of second stacked coils includes the second coil.
8. The waveguide assembly according to any of aspects 1 to 7, wherein the first and second coils each have a diameter of approximately 3-10mm.
9. The waveguide assembly according to any of aspects 1 to 8, wherein each of the first and second coils are positioned on the same side of the waveguide.
10. The waveguide assembly according to any of aspects 1 to 9, further comprising an electromagnetic reflector, wherein the waveguide is located between the reflector and the first and second coils.
11. The waveguide assembly according to any one of the previous aspects, in particular aspect 10, wherein the electromagnetic reflector is electrically grounded.
12. The waveguide assembly according to any of aspects 1 to 11, further comprising at least one magnetic shield member, each magnetic shield member comprising a ferromagnetic material, wherein a plane extending perpendicular to the longitudinal axis and through one of the first or second coils, extends through the at least one magnetic shield member.
13. The waveguide assembly according to any one of the previous aspects, in particular aspect 12, wherein:
   the at least one magnetic shield member comprises a lower magnetic shield member; and
   the first and second coils are located between the lower magnetic shield member and the waveguide.
14. The waveguide assembly according to any one of the previous aspects, in particular aspects 12 and 13, wherein:
   the at least one magnetic shield member comprises an upper magnetic shield member; and
   the waveguide is positioned between the first and second coils and the upper magnetic shield member.
15. The waveguide assembly according to any one of the previous aspects, in particular aspect 14, wherein:
   the first and second coils are located closer to a proximal end of the waveguide than a distal end of the waveguide; and
   the upper and lower magnetic shield members each include a proximal end corresponding to the proximal end of the waveguide and a distal end corresponding to the distal end of the waveguide; and
   a position of the distal end of the lower magnetic shield member along the longitudinal axis is offset toward the distal end of the waveguide relative to a position of the distal end of the upper magnetic shield member along the longitudinal axis.
16. A magnetostrictive position measuring system comprising:
   a waveguide having a longitudinal axis;
   an excitation generator configured generate an excitation signal that is conducted through the waveguide;
   a target magnet that is moveable along the longitudinal axis relative to the waveguide and is configured to generate an acoustic pulse carried by the waveguide in response to the excitation signal;
   a magnetostrictive response pickup comprising:
      a first coil oriented within a first plane, which is approximately parallel to the longitudinal axis; and
      a second coil connected in series with the first coil and oriented within a second plane, which is approximately parallel to the longitudinal axis,
      wherein a central axis of the first coil is displaced a coil separation distance from a central axis of the second coil along the longitudinal axis; and
   a signal conditioner configured to amplify signals conducted through the first and second coils in response to the acoustic pulse and output a conditioned response signal.
17. The system according to any one of the previous aspects, in particular aspect 16, wherein each of the first and second coils are spiral coils.
18. The system according to any one of the previous aspects, in particular aspects 16 to 17, wherein the coil separation distance is approximately one-half of a wavelength of the acoustic pulse carried by the waveguide.
19. The system according to any one of the previous aspects, in particular aspects 16 to 18, wherein the acoustic pulse comprises a torsional wave.
20. The system according to any one of the previous aspects, in particular aspects 16 to 18, wherein the acoustic pulse comprises a longitudinal wave.
21. The system according to any one of the previous aspects, in particular aspects 16 to 20, wherein the first and second planes are approximately parallel.
22. The system according to any one of the previous aspects, in particular aspects 16 to 21, wherein each of the first and second coils are formed in a layer of a printed circuit board.
23. The system according to any one of the previous aspects, in particular aspects 16 to 22, further comprising:
   a first coil assembly comprising a plurality of first stacked coils connected together in series, each first stacked coil being oriented within a plane that is approximately parallel to the longitudinal axis and approximately coaxial to the other first stacked coils, wherein the plurality of first stacked coils includes the first coil; and
   a second coil assembly comprising a plurality of second stacked coils connected together in series, each second stacked coil being oriented within a plane that is approximately parallel to the longitudinal axis and approximately coaxial to the other second stacked coils, wherein the plurality of second stacked coils includes the second coil.
24. The system according to any one of the previous aspects, in particular aspects 16 to 23, wherein each coil has a diameter of approximately 3-10mm.
25. The system according to any one of the previous aspects, in particular aspects 16 to 24, wherein each of the first and second coils are positioned on the same side of waveguide.
26. The system according to any one of the previous aspects, in particular aspects 16 to 25, further comprising an electromagnetic reflector, wherein each coil is located between the reflector and the waveguide.
27. The system according to any one of the previous aspects, in particular aspect 26, wherein the electromagnetic reflector is electrically grounded.
28. The system according to any one of the previous aspects, in particular aspects 16 to 27, further comprising at least one magnetic shield member, each comprising a ferromagnetic material, wherein a plane extending perpendicular to the longitudinal axis and through one of the first or second coils, extends through the at least one magnetic shield member.
29. The system according to any one of the previous aspects, in particular aspect 28, wherein:
   the at least one magnetic shield member comprises a lower magnetic shield member; and
   the first and second coils are located between the lower magnetic shield member and the waveguide.
30. The system according to any one of the previous aspects, in particular aspects 28 and 29, wherein:
   the at least one magnetic shield member comprises an upper magnetic shield member; and
   the waveguide is positioned between the first and second coils and the upper magnetic shield member.
31. The system according to any one of the previous aspects, in particular aspect 30, wherein:
   the first and second coils are located closer to a proximal end of the waveguide than a distal end of the waveguide; and
   the upper and lower magnetic shield members each include a proximal end corresponding to the proximal end of the waveguide and a distal end corresponding to the distal end of the waveguide; and
   a position of the distal end of the lower magnetic shield member along the longitudinal axis is offset toward the distal end of the waveguide relative to a position of the distal end of the upper magnetic shield member along the longitudinal axis.
32. The system according to any one of the previous aspects, in particular aspects 16 to 30, wherein:
   the first and second coils having an impedance of about 1-3 ohms;
   the signal conditioner comprises:
      a first stage amplifier having an impedance that approximately matches the impedance of coils, the first stage amplifier configured to amplify the signals conducted through the first and second coil and output corresponding first stage signals; and
      a second stage amplifier having a high impedance configured to amplify the first stage signals and output corresponding second stage signals.
33.The system according to any one of the previous aspects, in particular aspect 32, wherein:
   an output section of the first stage amplifier has an impedance of about 24 - 50 kohms; and
   an input section of the second stage amplifier has an impedance that approximately matches the impedance of the output section of the first stage amplifier.
34. The system according to any one of the previous aspects, in particular aspect 33, wherein:
   the first stage amplifier has a gain of approximately 800-1200; and
   the second stage amplifier has a gain of approximately 8-12.
35. The system according to any one of the previous aspects, in particular aspects 32 to 34, wherein the signal conditioner further comprises:
   a rectification circuit configured to rectify the second stage signals; and
   a demodulator configured to demodulate the rectified second stage signals.
36. The system according to any one of the previous aspects, in particular aspects 16 to 35, further comprising a controller configured to determine a position of the target magnet along the waveguide using the conditioned response signal.
37. A method comprising forming a waveguide assembly for a magnetostrictive position measuring system including:
   providing a waveguide having a longitudinal axis;
   forming a magnetostrictive response pickup comprising:
      forming a first coil that is oriented within a first plane, which is approximately parallel to the longitudinal axis; and
      forming a second coil that is connected in series with the first coil and is oriented within a second plane, which is approximately parallel to the longitudinal axis,
      wherein a central axis of the first coil is displaced a coil separation distance from a central axis of the second coil along the longitudinal axis.
38. The method according to any one of the previous aspects, in particular aspect 37, wherein the coil separation distance is approximately one-half of a wavelength of an acoustic pulse magnetostrictive response carried by the waveguide.
39. The method according to any one of the previous aspects, in particular aspects 37 to 38, wherein the first and second planes are approximately parallel.
40. The method according to any one of the previous aspects, in particular aspects 37 to 39, wherein each of the first and second coils are spiral coils.
41. The method according to any one of the previous aspects, in particular aspects 37 to 40, wherein the first and second coils each have a diameter of approximately 3-10mm.
42. The method according to any one of the previous aspects, in particular aspects 37 to 41, wherein each of the first and second coils are positioned on the same side of waveguide.
43. The method according to any one of the previous aspects, in particular aspects 37 to 42, wherein:
   forming the first coil comprises forming the first coil using conductive traces in a printed circuit board; and
   forming the second coil comprises forming the second coil using conductive traces in the printed circuit board.
44. The method according to any one of the previous aspects, in particular aspects 37 to 43, wherein:
   forming the first coil comprises forming a first coil assembly comprising a plurality of first stacked coils connected together in series, each first stacked coil being oriented within a plane that is approximately parallel to the longitudinal axis and approximately coaxial to the other first stacked coils, wherein the plurality of first stacked coils includes the first coil; and
   forming the second coil comprises forming a second coil assembly comprising a plurality of second stacked coils connected together in series, each second stacked coil being oriented within a plane that is approximately parallel to the longitudinal axis and approximately coaxial to the other second stacked coils, wherein the plurality of second stacked coils includes the second coil.
45. The method according to any one of the previous aspects, in particular aspects 37 to 44, further comprising forming an electromagnetic reflector, wherein the waveguide is located between the reflector and the first and second coils.
46. The method according to any one of the previous aspects, in particular aspect 45, further comprising electrically grounding the electromagnetic reflector.
47. The method according to any one of the previous aspects, in particular aspects 37 to 46, further comprising forming at least one magnetic shield member, each magnetic shield member comprising a ferromagnetic material, wherein a plane extending perpendicular to the longitudinal axis and through one of the first or second coils, extends through the at least one magnetic shield member.
48. The method according to any one of the previous aspects, in particular aspect 47, wherein:
   forming the at least one magnetic shield member comprises forming a lower magnetic shield member; and
   the first and second coils are located between the lower magnetic shield member and the waveguide.
49. The method according to any one of the previous aspects, in particular aspects 47 to 48, wherein:
   forming the at least one magnetic shield member comprises forming an upper magnetic shield member; and
   the waveguide is positioned between the first and second coils and the upper magnetic shield member.
50. The method according to any one of the previous aspects, in particular aspect 49, wherein:
   the first and second coils are located closer to a proximal end of the waveguide than a distal end of the waveguide; and
   the upper and lower magnetic shield members each include a proximal end corresponding to the proximal end of the waveguide and a distal end corresponding to the distal end of the waveguide; and
   a position of the distal end of the lower magnetic shield member along the longitudinal axis is offset toward the distal end of the waveguide relative to a position of the distal end of the upper magnetic shield member along the longitudinal axis.

## Claims

1. A waveguide assembly for a magnetostrictive position measuring system, the waveguide assembly comprising:
a waveguide having a longitudinal axis; and
a magnetostrictive response pickup comprising:
a first coil oriented within a first plane, which is approximately parallel to the longitudinal axis; and
a second coil connected in series with the first coil and oriented within a second plane, which is approximately parallel to the longitudinal axis,
wherein a central axis of the first coil is displaced a coil separation distance from a central axis of the second coil along the longitudinal axis.

2. The waveguide assembly according to claim 1, wherein the coil separation distance is approximately one-half of a wavelength of an acoustic pulse magnetostrictive response carried by the waveguide.

3. The waveguide assembly according to any one of the previous claims, wherein the acoustic pulse comprises a torsional wave or a longitudinal wave.

4. The waveguide assembly according to any one of the previous claims, wherein the first and second planes are approximately parallel.

5. The waveguide assembly according to any one of the previous claims, wherein each of the first and second coils are spiral coils.

6. The waveguide assembly according to any one of the previous claims, further comprising:
a first coil assembly comprising a plurality of first stacked coils connected together in series, each first stacked coil being oriented within a plane that is approximately parallel to the longitudinal axis and approximately coaxial to the other first stacked coils, wherein the plurality of first stacked coils includes the first coil; and
a second coil assembly comprising a plurality of second stacked coils connected together in series, each second stacked coil being oriented within a plane that is approximately parallel to the longitudinal axis and approximately coaxial to the other second stacked coils, wherein the plurality of second stacked coils includes the second coil.

7. The waveguide assembly according to any one of the previous claims, wherein the first and second coils each have a diameter of approximately 3-10mm and the first and second coils are positioned on the same side of the waveguide.

8. The waveguide assembly according to any one of the previous claims, further comprising an electromagnetic reflector that is electrically grounded and located between the reflector and the first and second coils.

9. The waveguide assembly according to any one of the previous claims, further comprising at least one magnetic shield member, each magnetic shield member comprising a ferromagnetic material, wherein a plane extending perpendicular to the longitudinal axis and through one of the first or second coils, extends through the at least one magnetic shield member; and in a further embodiment, wherein: the at least one magnetic shield member comprises a lower magnetic shield member; and the first and second coils are located between the lower magnetic shield member and the waveguide; and in yet a further embodiment, wherein: the at least one magnetic shield member comprises an upper magnetic shield member; and the waveguide is positioned between the first and second coils and the upper magnetic shield member, and in yet a further embodiment, wherein: the first and second coils are located closer to a proximal end of the waveguide than a distal end of the waveguide; the upper and lower magnetic shield members each include a proximal end corresponding to the proximal end of the waveguide and a distal end corresponding to the distal end of the waveguide; and a position of the distal end of the lower magnetic shield member along the longitudinal axis is offset toward the distal end of the waveguide relative to a position of the distal end of the upper magnetic shield member along the longitudinal axis.

10. A magnetostrictive position measuring system comprising:
a waveguide having a longitudinal axis;
an excitation generator configured generate an excitation signal that is conducted through the waveguide;
a target magnet that is moveable along the longitudinal axis relative to the waveguide and is configured to generate an acoustic pulse carried by the waveguide in response to the excitation signal;
a magnetostrictive response pickup comprising:
a first coil oriented within a first plane, which is approximately parallel to the longitudinal axis; and
a second coil connected in series with the first coil and oriented within a second plane, which is approximately parallel to the longitudinal axis,
wherein a central axis of the first coil is displaced a coil separation distance from a central axis of the second coil along the longitudinal axis; and
a signal conditioner configured to amplify signals conducted through the first and second coils in response to the acoustic pulse and output a conditioned response signal.

11. The system according to claim 10, wherein:
the first and second coils having an impedance;
the signal conditioner comprises:
a first stage amplifier having an impedance that approximately matches the impedance of coils, the first stage amplifier configured to amplify the signals conducted through the first and second coil and output corresponding first stage signals; and
a second stage amplifier having a high impedance configured to amplify the first stage signals and output corresponding second stage signals, and in a further embodiment, wherein: an output section of the first stage amplifier has an impedance; and an input section of the second stage amplifier has an impedance that approximately matches the impedance of the output section of the first stage amplifier, and in yet a further embodiment, wherein: the first stage amplifier has a first gain; and the second stage amplifier has a second gain of one one-hundredth of the first gain.

12. The system according to claim 11, wherein the signal conditioner further comprises:
a rectification circuit configured to rectify the second stage signals; and
a demodulator configured to demodulate the rectified second stage signals.

13. The system according to any one of claims 10-12, further comprising a controller configured to determine a position of the target magnet along the waveguide using the conditioned response signal.

14. A method comprising forming a waveguide assembly for a magnetostrictive position measuring system including:
providing a waveguide having a longitudinal axis; and
forming a magnetostrictive response pickup comprising:
forming a first coil that is oriented within a first plane, which is approximately parallel to the longitudinal axis; and
forming a second coil that is connected in series with the first coil and is oriented within a second plane, which is approximately parallel to the longitudinal axis,
wherein a central axis of the first coil is displaced a coil separation distance from a central axis of the second coil along the longitudinal axis.

15. The method according to claim 14, wherein:
the coil separation distance is approximately one-half of a wavelength of an acoustic pulse magnetostrictive response carried by the waveguide;
the first and second planes are approximately parallel;
each of the first and second coils are spiral coils;
the first and second coils each have a diameter of approximately 3-10mm;
each of the first and second coils are positioned on the same side of waveguide;
forming the first coil comprises forming the first coil using conductive traces in a printed circuit board;
forming the second coil comprises forming the second coil using conductive traces in the printed circuit board;
forming the first coil comprises forming a first coil assembly comprising a plurality of first stacked coils connected together in series, each first stacked coil being oriented within a plane that is approximately parallel to the longitudinal axis and approximately coaxial to the other first stacked coils, wherein the plurality of first stacked coils includes the first coil;
forming the second coil comprises forming a second coil assembly comprising a plurality of second stacked coils connected together in series, each second stacked coil being oriented within a plane that is approximately parallel to the longitudinal axis and approximately coaxial to the other second stacked coils, wherein the plurality of second stacked coils includes the second coil;
the method includes forming an electromagnetic reflector, wherein the waveguide is located between the reflector and the first and second coils.
the method includes electrically grounding the electromagnetic reflector;
the method includes forming at least one magnetic shield member, each magnetic shield member comprising a ferromagnetic material, wherein a plane extending perpendicular to the longitudinal axis and through one of the first or second coils, extends through the at least one magnetic shield member;
forming the at least one magnetic shield member comprises forming a lower magnetic shield member;
the first and second coils are located between the lower magnetic shield member and the waveguide;
forming the at least one magnetic shield member comprises forming an upper magnetic shield member;
the waveguide is positioned between the first and second coils and the upper magnetic shield member;
the first and second coils are located closer to a proximal end of the waveguide than a distal end of the waveguide;
the upper and lower magnetic shield members each include a proximal end corresponding to the proximal end of the waveguide and a distal end corresponding to the distal end of the waveguide; and/or
a position of the distal end of the lower magnetic shield member along the longitudinal axis is offset toward the distal end of the waveguide relative to a position of the distal end of the upper magnetic shield member along the longitudinal axis.
